Europäisches Patentamt

(19) European Patent Office

Office européen des brevets

(11) Publication number: **0 060 033**
**A1**

## (12) EUROPEAN PATENT APPLICATION

(21) Application number: 82300706.7

(22) Date of filing: 12.02.82

(51) Int. Cl.³: **H 01 S 3/23**
**H 01 S 3/13**

(30) Priority: 16.02.81 GB 8104828

(43) Date of publication of application:
15.09.82 Bulletin 82/37

(84) Designated Contracting States:
AT BE CH DE FR GB IT LI LU NL SE

(71) Applicant: BRITISH TELECOMMUNICATIONS
2-12 Gresham Street
London E2V 7AG(GB)

(72) Inventor: Malyon, Derek John
6 Burnham Lodge Oakstead Close
Ipswich Suffolk(GB)

(72) Inventor: Smith, David William
22 Baronsdale Close
Ipswich Suffolk(GB)

(72) Inventor: Berry, Ronald William
Aaron House Finchley Road
Ipswich Suffolk(GB)

(74) Representative: Smith, Norman Ian et al,
F.J. CLEVELAND & COMPANY 40-43 Chancery Lane
London WC2A 1JQ(GB)

(54) Improvements in or relating to laser light sources.

(57) A light source comprises a first laser 10 and a second laser 11 which is arranged so that light from the first laser can be injected into the second. The bias to the lasers is controlled so that the first laser acts as an oscillator and the second laser as a modulator, the output from the modulator being a single longitudinal mode. A low frequency signal is applied to the first laser 10 and detected in the output of the second laser 11. A phase sensitive detector 18 is responsive to the sensed signal to provide a feedback signal for the second laser 11 such that the cavity modes of the two lasers are aligned automatically.

FIG.1

EP 0 060 033 A1

COMPLETE DOCUMENT

- 2 -

## DESCRIPTION

This invention relates to laser light sources. The invention has particular application to laser light sources which are used in optical fibre communication systems.

It is known that optical injection into a semiconductor laser enhances many of its static and dynamic characteristics. For example, it is known that optical injection results in a reduction of relaxation oscillations and patterning effects together with the narrowing of the spectral linewidth. There is a requirement in optical fibre communication systems for a single longitudinal mode high speed modulated semiconductor laser which is insensitive to reflections, particularly within the low loss optical fibre region around 1.5µm. Although dynamic single mode operation in for example channelled substrate planar devices has been achieved, their extinction ratio and spectral instability due to reflections is poor. Furthermore, it has been found difficult to achieve a means for laser level control which will maintain the single mode operation.

It has been proposed to provide a light source which has a pair of lasers, the lasers being arranged so that light from one can be injected into the other to stimulate the other laser. The lasers are controlled such that the optical output of the source is a single longitudinal mode. In such a source it is important to align the cavity modes of the two lasers and the present invention is concerned with an arrangement in which this alignment can be carried out automatically.

According to the present invention there is provided a light source comprising a first laser, a second laser arranged such that light from the first laser can be injected into said second laser to stimulate said second laser, and means for controlling said lasers such that the optical output of the source is a single longitudinal mode, characterised in that the control means includes means for applying a varying signal to one of said lasers, means for sensing the varying signal at or in the output of the second laser, and means responsive to the sensed signal for controlling one or both of the lasers such that their cavity modes are aligned.

The control means may include means for injecting a low frequency current on the bias of the first laser, a photoelectric detector for sensing the optical output of the second laser and a phase sensitive detector connected to said photoelectric detector and arranged to provide a feedback signal for controlling the bias or temperature of the second laser.

The lasers may have a different cavity Q whereby the optical power injected into the second laser can be selected such that the vernier mode is suppressed.

The first laser may be a channelled substrate planar device and the second laser may be a multi-longitudinal moded gain guided device.

The invention will be described now by way of example only with particular reference to the accompanying drawings. In the drawings:

Figure 1 is a block schematic diagram of a light source in accordance with the present invention;

Figure 2 is a graph illustrating the operation of the present invention, and

Figures 3a to 3c illustrate optical outputs which can be obtained from the light source.

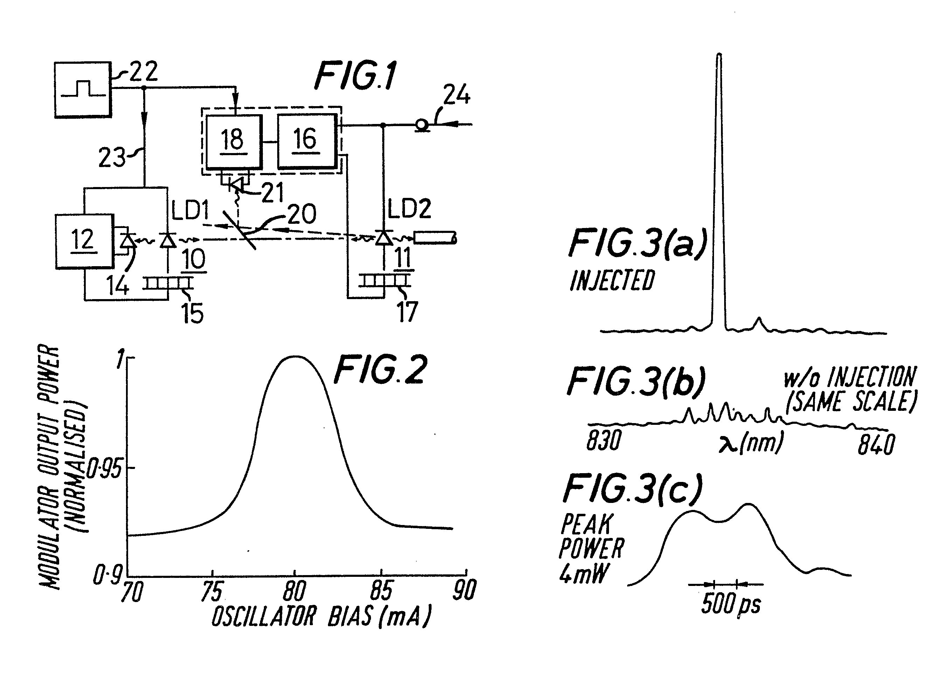

Referring to Figure 1 a light source comprises first and second semiconductor lasers 10 and 11. The laser 10 is arranged to operate as an oscillator laser and is a channelled substrate planar device with a strong gain suppression characteristic. Associated with the laser 10 is a wavelength sensed power and wavelength control circuit 12 which has associated therewith a wavelength detector 14 which is arranged to receive light emitted by the laser 10. A Peltier unit 15 is connected in circuit with the control circuit 12 and the laser 10.

The laser 11 is arranged so that light from the laser 10 can be injected into the laser 11. The laser 11 has a temperature and bias tuning circuit 16 together with a Peltier unit 17. Associated with the temperature and bias tuning circuit 16 is a phase sensitive detector 18 which has a photo diode 31 arranged to receive light from the laser 11 by way of a beam splitter 20 which is disposed in the light path between the laser 10 and the laser 11. The phase sensitive detector is arranged to receive a low frequency signal from a low frequency generating circuit 22 the output from which can also be applied to the laser 10 by way of line 23. Data in the form of electrical pulses can be applied to the light source for conversion to optical pulses by way of line 24.

In operation the laser 10 is controlled such that it provides a continuous wave single mode optical output. The control of the injection current and heat sink temperature is provided by the circuit 12. One way in which wavelength control of the oscillator can be achieved is described in an article entitled "Wavelength sensed mode control of semiconductor lasers", Electronics Letters, Volume 16, No. 19, 1980.

The laser 11 is a modulator laser and is a multi-longitudinal moded gain guided device. In order to obtain from the laser 11 a dynamic single mode optical output with a stabilised spectrum it is necessary to align the cavity mode of the laser 11 with the cavity mode of the laser 10. This is achieved using the Peltier units 15 and 17 and by controlling the bias current temperature tuning of the lasers. With the optical output from the laser 10 injected into the laser 11 the modulator laser 11 can be locked to the oscillator laser using the relationship illustrated in Figure 2. This Figure shows the relationship between the injection current of the oscillator laser 10 and the output power of the modulator laser 11 and it can be seen that the output power from the modulator laser rises to a peak and then decreases as the oscillator bias current is increased. Small changes of bias current to the oscillator laser changes the wavelength of its cavity modes by effectively modifying the cavity length. Consequently there is a value of bias current where a cavity mode of the oscillator coincides with a cavity mode of the modulator. Similarly variations of the bias current to the modulator lasers modifies the wavelength of its cavity modes. When a cavity mode of the oscillator aligns with that of the modulator, the output power from the modulator will reach a maxima. Optimum operation is achieved when the modulator optical output power is at the peak. This position is maintained by using the circuit 22 in conjunction with the phase sensitive detector 18 and the temperature and bias tuning circuit 16 together with the beam splitter 20. The circuit 22 is used to impose a small LF current on the oscillator bias current so that a small low frequency signal appears in the output of the modulator. This low frequency output is phase detected by the phase sensitive detector 18 and the optimum operating point is maintained by feeding back the signal from the phase sensitive detector to control the bias applied to the laser 11. The feedback arrangement operates to adjust the bias of the laser 11 so that the laser 11 operates at its peak power.

The superimposed LF signal changes the wavelength of the oscillator laser 10 at a faster rate than the wavelength control circuit 12 can provide corrections. Consequently an LF signal is seen at the output of the modulator 11. The phase of the detected LF frequency indicates which side of the maxima of Figure 2 a cavity mode of the oscillator laser is in relationship to a cavity mode of the modulator. When the cavity modes are aligned the LF signal will be nulled. To align the cavity modes, not only control of the bias current can be employed but control of the operating temperature of either laser can be used.

In operating the light source shown in Figure 1 it is important that the optical power injected into the laser 11 is maintained sufficiently low to suppress the vernier mode. The vernier mode results because the two lasers 10 and 11 have different cavity lengths, i.e. different effective cavity Q's, and thus different Fabry-Perot mode spacings. When two modes are aligned at a particular wavelength there will be other wavelengths where there will be close alignment. Optical injection of the modulator laser for continuous wave operation selectively enhances a particular longitudinal mode while the gain of other modes is suppressed.

A typical stable single mode spectrum obtained from the source of Figure 1 is shown in Figure 3a for continuous wave operation at a wavelength of 834 nm. Figure 3c shows a pulse response of the laser source for which the extinction ratio was 0.07. For reference the spectrum of the laser source without optical injection is illustrated in Figure 3b. The results shown in Figure 3 were obtained when the laser source was butt coupled into two metres of monomode fibre tail and a highly reflecting surface introduced at the far end of the fibre tail.

For comparison direct modulation of a similar laser to the laser 10 did not produce stable single mode operation when deliberate reflections were introduced during fibre handling. Thus, an optical isolator would be required in order to achieve such operation. Furthermore the extinction ratio to achieve single mode operation was worse than 0.25.

Thus in summary the present light source provides a single mode optical output. This is achieved using a light source which has an oscillator laser and a modulator laser. The oscillator has a wavelength sensed feedback which allows single mode operation to be achieved even if there are changes in ambient temperature or thermal impedance. The light from the oscillator laser is injected into the modulator laser to produce the single mode optical output. Any type of semiconductor laser can be used but the gain profile of the two lasers used in a source should be matched to within about 10 nm.

It will be appreciated that similar results at other wavelengths can be achieved.

An advantage of the present technique is that optical injection seems to reduce reflection noise problems which has considerable benefits in optical fibre communication systems. Furthermore the source has an extremely narrow line width which results in a relaxation of the requirement for total dispersion minimisation in the optical fibre itself thus easing design problems for fibre optic systems.

In addition to its use in optical fibre communications there are other applications for the present source. It could be used, for example, in wavelength multiplexed systems at all optical wavelengths, as a stable source in measuring equipment, and in systems employing resonant laser amplifiers.

As described above the low frequency modulation is applied to the first laser and detected in the light output of the second laser. Alternatively the modulation could be detected by sensing the junction voltage of the second laser. Also the modulation could be applied to the second laser. In a further alternative the control signal/bias adjustment can be applied to the laser 10, the low frequency modulation applied to either laser, and the modulation detected at the laser 11.

## CLAIMS

1. A light source comprising a first laser (10), a second laser (11) arranged such that light from the first laser can be injected into said second laser to stimulate said second laser (11), and means for controlling said lasers such that the optical output of the source is a single longitudinal mode, characterised in that the control means includes means (22) for applying a varying signal to one of said lasers, means (21) for sensing the varying signal at or in the output of the second laser (11), and means (18, 16) responsive to the sensed signal for controlling one or both of the lasers such that their cavity modes are aligned.

2. A light source as claimed in claim 1 characterised in that the control means includes means (22) for injecting a low frequency current on the bias of the first laser (10), a photoelectric detector (21) for sensing the optical output of the second laser (11), and a phase sensitive detector (18) connected to said photoelectric detector and arranged to provide a feedback signal for controlling the bias or temperature of the second laser.

3. A light source as claimed in claim 1 or claim 2 characterised in that the lasers (10, 11) have a different cavity Q whereby the optical power injected into the second laser (11) can be selected such that the vernier mode is suppressed.

4. A light source as claimed in any preceding claim characterised in that the first laser (10) is operated in a stable continuous wave single mode and the control means for the first laser includes a wavelength sensed feedback (12) for controlling power and wavelength.

5. A light source as claimed in claim 4 characterised in that the control means also includes a Peltier unit (15).

6. A light source as claimed in any preceding claim characterised in that the control means for the second laser includes a temperature bias tuning unit (16).

7. A light source as claimed in any preceding claim characterised in that the first laser (10) is a channelled substrate planar device and the second laser (11) is a multi-longitudinal moded gain guided device.

FIG.1

FIG.2

MODULATOR OUTPUT POWER (NORMALISED)

OSCILLATOR BIAS (mA)

FIG.3(a)
INJECTED

FIG.3(b)  w/o INJECTION
(SAME SCALE)

830    λ(nm)    840

FIG.3(c)
PEAK POWER
4mW

500 ps

1/1

0060033

**European Patent Office**

## EUROPEAN SEARCH REPORT

EP  82 30 0706

### DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | APPLIED PHYSICS LETTERS, vol. 35, no. 11, December 1979, pages 835-838, New York (USA); G.MEGIE et al.: "Tunable single-longitudinal-mode operation of an injection-locked TEA CO2 laser". *Page 836, left-hand column, last paragraph; figure 1* | 1 | H 01 S   3/23<br>H 01 S   3/13 |
| A | APPLIED PHYSICS LETTERS *Idem* | 3,4 | |
| A | ELECTRONICS LETTERS, vol. 16, no. 19, 11th September 1980, pages 746-748, Hitchin Herts (GB); S. KOBAYASHI et al.: "Single-mode operation of 500 Mbit/s modulated AlGaAs semiconductor laser by injection locking". *Page 746; page 747, left-hand column, lines 1-5; figures 1,2,4* | 1,4-6 | |
| A | JAPANESE JOURNAL OF APPLIED PHYSICS, vol. 16, no. 12, December 1977, pages 2221-2225, Tokyo (JP); G.MOTOSUGI: "Single longitudinal mode oscillation of semiconductor lasers by optical coupling". *Page 2221; pages 2223-2224; paragraph 3.3 * | 1,3 | |

**TECHNICAL FIELDS SEARCHED (Int. Cl. ³)**

H 01 S   3/10
H 01 S   3/13
H 01 S   3/23
H 01 S   3/098
H 04 B   9/00

The present search report has been drawn up for all claims

| Place of search | Date of completion of the search | Examiner |
|---|---|---|
| THE HAGUE | 04-06-1982 | BORMS F. |

**European Patent Office**

**EUROPEAN SEARCH REPORT**

| DOCUMENTS CONSIDERED TO BE RELEVANT | | | Page 2 | |
|---|---|---|---|---|
| Category | Citation of document with indication, where appropriate, of relevant passages | Relevant to claim | CLASSIFICATION OF THE APPLICATION (Int. Cl. ³) | |
| A | FR-A-2 306 551 (LICENTIA) *Page 2, lines 3-14; page 3, line 29 - page 4, line 13; page 6, lines 24-30; figures 1,13* | 1,3 | | |
| A | US-A-4 038 610 (J.NISHIZAWA et al.) *Column 1, lines 13-18; column 5, lines 19-50; figure 15* | 1 | | |
| A | US-A-3 999 146 (R.LANG et al.) *Column 1, lines 50-57; column 3, line 17 - column 4, line 18* | 1 | | |
| A | US-A-3 609 583 (H.BRUN) *Column 2, lines 20-27; figure 2* | 2,4 | | |
| A | JAPANESE JOURNAL OF APPLIED PHYSICS, vol. 19, no. 12, December 1980, pages L721-L724, Tokyo (JP); H.TSUCHIDA et al.: "Frequency stability measurement of feedback stabilized AlGaAs DH laser". *Pages L721-L722, paragraph 2, figure 1* | 2,4-6 | TECHNICAL FIELDS SEARCHED (Int. Cl. ³) | |

The present search report has been drawn up for all claims

| Place of search | Date of completion of the search | Examiner |
|---|---|---|
| THE HAGUE | 04-06-1982 | BORMS F. |

0060033

European Patent
Office

EUROPEAN SEARCH REPORT

Application number

EP 82 30 0706

| DOCUMENTS CONSIDERED TO BE RELEVANT | | | Page 3 |
|---|---|---|---|

| Category | Citation of document with indication, where appropriate, of relevant passages | Relevant to claim | CLASSIFICATION OF THE APPLICATION (Int. Cl. ³) |
|---|---|---|---|
| A,D | ELECTRONICS LETTERS, vol. 16, no. 19, 11th September 1980, pages 744-746, Hitchin, Herts (GB); D.J.MALYON et al.: "Wavelength sensed mode control of semiconductor lasers". *Page 745, right-hand column, paragraph 1, figure 1* | 4-6 | |
| | --- | | |
| A | EP-A-0 001 714 (THE POST OFFICE) *Claims 1 and 8* | 4 | |
| | ----- | | |

**TECHNICAL FIELDS SEARCHED (Int. Cl. ³)**

The present search report has been drawn up for all claims

| Place of search THE HAGUE | Date of completion of the search 04-06-1982 | Examiner BORMS F. |
|---|---|---|